# FASCICULE DE BREVET EUROPEEN

(11) **EP 1 754 070 B1**
(45) Date de publication et mention de la délivrance du brevet: **17.12.2008**
(21) Numéro de dépôt: 05766705.7
(22) Date de dépôt: 30.05.2005
(51) Int. Cl.: G01R 31/00, G05B 23/02

(54) **PROCEDE ET DISPOSITIF DE CONTROLE DU FONCTIONNEMENT D'UN ORGANE ELECTRIQUE D'UN VEHICULE AUTOMOBILE**
VERFAHREN UND VORRICHTUNG ZUR STEUERUNG DES BETRIEBS EINES ELEKTRISCHEN ELEMENTS EINES KRAFTFAHRZEUGS
METHOD AND DEVICE FOR CONTROLLING THE OPERATION OF AN ELECTRIC ELEMENT OF A MOTOR VEHICLE

(30) Priorité: 10.06.2004 FR 0451260
(43) Date de publication de la demande: 21.02.2007
(73) Titulaire: Peugeot Citroën Automobiles, 78140 Vélizy-Villacoublay (FR)
(72) Inventeur: LOPEZ, Thierry, F-78700 CONFLANS STE HONORINE (FR)
(86) Numéro de dépôt international: PCT/FR2005/050385
(87) Numéro de publication internationale: WO 2006/000723

(56) Documents cités:
- DE-A- 4 105 075
- FR-A- 2 766 285
- FR-A- 2 799 284
- FR-A- 2 812 946
- FR-A- 2 826 745
- US-A- 5 003 478
- US-A- 5 950 144

## Description

L'invention se rapporte à un procédé de contrôle du fonctionnent d'un organe électrique et à un dispositif de mise en oeuvre dudit procédé.

L'invention concerne plus particulièrement un procédé de contrôle de la conformité de production, utilisé en bout de ligne de montage d'un véhicule automobile et à un dispositif permettant la mise en oeuvre d'un tel procédé.

Il est connu de procéder à un contrôle systématique du fonctionnement des différents organes électriques, tels des capteurs de mesure ou des actionneurs. Les véhicules automobiles comprennent des capteurs mesurant les différents paramètres de fonctionnement du véhicule ainsi que des actionneurs agissant sur le fonctionnement du véhicule. En effet, dans une volonté de rendre la conduite plus agréable et confortable au conducteur et aux passagers des véhicules, de nombreux capteurs et actionneurs assistent ou informent les conducteurs dans la conduite du véhicule.

Afin de vérifier la conformité des liaisons électriques entre les organes électriques précédemment cités, il est d'usage de procéder à un contrôle en ligne de montage d'un véhicule. Compte tenu que nombre d'organes sont liés physiquement par une liaison électrique à au moins un calculateur, il est d'usage d'appliquer un premier contrôle destiné à diagnostiquer l'existence de la liaison électrique entre les organes électriques et leurs calculateurs de commande. Pour cela, il est connu de disposer dans une mémoire dédiée de chaque organe électrique un code électronique qualifié de code d'identification, qui sera systématiquement lu par un calculateur lors d'une mise sous tension. Un dispositif de diagnostic présent en bord de ligne de montage permet alors d'interroger de manière séquentielle chacun des calculateurs afin de lire les différents codes d'identification. Le dispositif de diagnostic des organes électriques équipant le véhicule comporte aussi une cartographie des différents codes d'identification de chaque véhicule de sorte qu'une comparaison des données entre les identifiants et la cartographie, rend apte l'appréciation de la qualité des liaisons électriques et la connaissance des organes électriques équipant le véhicule.

La liaison entre un circuit électrique et certains organes électriques ne peut malheureusement pas être contrôlée de cette manière. En effet, certains organes électriques ne sont pas pilotés par des calculateurs de sorte que le système informatique embarqué sur le véhicule n'est apte à lire lecode d'identification de ce type d'organe électrique. Il est ainsi connu que des organes électriques, telle une lunette arrière chauffante qui est un organe électrique consommant une quantité importante d'énergie électrique, sont commandés en fonctionnement par des sélecteurs de commande manuelle.

D'autres organes électriques liés au système informatique du véhicule nécessitent quant à eux le fonctionnement du véhicule pour permettre un diagnostic de leur fonctionnement, ceci étant notamment le cas de certains capteurs de mesure, tel celui lié au calculateur commandant le fonctionnement du système de climatisation du véhicule par exemple.

Ainsi, le procédé de contrôle visant à diagnostiquer les organes électriques trouve ses limites de fonctionnements aux seuls organes électriques dont le fonctionnement est piloté par au moins un calculateur du système informatique embarqué sur le véhicule.

II est alors connu un second contrôle de la conformité de production utilisé pour les organes électriques qui soit ne peuvent être diagnostiqués que par une mise en condition de fonctionnement nominale du véhicule, soit ne sont pas liés au système informatique embarqué sur le véhicule. Ledit second contrôle consiste en la mesure d'une grandeur physique, tel le courant consommé par leur mise en fonctionnement. Il est alors connu d'utiliser une pince ampèremétrique destinée à l'analyse du champ magnétique créé par la circulation d'un courant dans le circuit de puissance électrique auquel est lié ledit organe électrique à contrôler.

II a été cependant relevé une certaine incertitude quant à la qualité des mesures de courant effectuées. En effet, il a été constaté la présence de perturbations du signal mesuré provenant d'organes électriques qualifiés de perturbateurs devant être isolés du circuit de puissance du véhicule. La cause de la perturbation est connue, s'agissant d'un signal de commande en fréquence d'un autre organe, qualifié d'organe perturbateur, qui consomme une quantité d'énergie importante et parfois même supérieure à celle du signal à mesurer. Compte tenu que chaque organe électrique est lié à au moins un connecteur qui est destiné à coopérer avec un autre connecteur, de forme antagoniste, lié audit circuit de puissance du véhicule, l'isolation dudit organe perturbateur est ainsi réalisée par une séparation physique desdits connecteurs.

La demanderesse a constaté des risques de détérioration des connecteurs lorsque sont réalisées des opérations répétées de connexion/déconnexion des organes électriques qualifiés d'organes perturbateurs au circuit de commande ou de puissance. En effet, une fois le contrôle de la connection électrique réalisé pour un organe consommateur de courant, la liaison électrique dudit organe perturbateur redevient effective par une opération visant à brancher lesdits connecteurs. Les connecteurs, étant conçu pour assurer une liaison électrique permanente, par exemple entre un organe électrique et un circuit de puissance, les opérations consistant à débrancher puis à brancher lesdits connecteurs sont de préférence à proscrire. En effet, le risque de détériorer physiquement un élément de connexion, telle une broche métallique conductrice d'électricité, est connu et nécessite en cas de détérioration des temps de réparation longs qui sont donc coûteux pour des fabrications en grande série de véhicules sur des chaînes de production.

Le document FR2799284 décrit un procédé de contrôle du fonctionnement d'organes électriques, pilotés par un calculateur embarqué à bord d'un véhicule automobile et raccordés à une source d'alimentation en énergie électrique commune à tous les organes électriques. Le procédé fait appel à un capteur de courant associé à la source d'alimentation commune et dont la sortie est reliée au calculateur. Le calculateur mémorise la cartographie de la consommation en courant des organes et analyse la sortie du capteur de courant à chaque changement d'état d'un organe. Une comparaison est ensuite établie entre la cartographie mémorisée et une cartographie stockée afin de détecter un dysfonctionnement de l'organe en cas de discordance entre les valeurs de courant réelles de la cartographie mémorisée et les valeurs de courant théoriques de la cartographie stockée.

Le document FR2766285 décrit un procédé de commande d'un système (véhicule auto, moteur ou transmission par ex) pour activer des modules (organes) présentant des relations dépendantes transversales. Avant d'activer un nouvel organe, on interroge les organes déjà activés. Des premières mémoires contiennent des informations concernant la perturbation réciproque des organes, des secondes mémoires contiennent des informations relatives aux organes déjà activés. Un séquenceur détermine à l'aide de ces mémoires si l'activation d'un nouvel organe risque de provoquer des perturbations entre les organes et évite l'activation simultanée d'organes susceptibles de se perturber réciproquement.

La présente invention a trait à un procédé de contrôle du fonctionnement d'au moins un premier organe (60) électrique relié à au moins un circuit de puissance (40) et/ou un circuit de commande (1) d'un véhicule automobile, un code (110) applicatif principal ayant été téléchargé dans une mémoire (11) d'un calculateur (10) pilotant un deuxième organe (50) électrique, caractérisé en ce qu'il consiste à télécharger des données (200) dans une mémoire (12) temporaire du calculateur (10), les données étant un code (120) applicatif secondaire et un marqueur (121) associé, à initialiser des registres du calculateur (10), à lire le contenu de la mémoire (12) temporaire du calculateur (10), à exécuter un code (110, 120) applicatif, le code (110) applicatif principal étant exécuté en une absence du code (120) applicatif secondaire de la mémoire (12) temporaire du calculateur (10), une exécution du code (110) applicatif principal étant destinée à piloter le fonctionnement nominal de l'organe (50) électrique, une exécution du code (120) applicatif secondaire visant à inhiber le fonctionnement de l'organe (50) électrique, l'isolant de la sorte du circuit (40) de puissance, puis à utiliser un moyen (30) de mesure d'un courant circulant dans le circuit (40) de puissance pour contrôler le fonctionnement de l'organe (60) électrique.

La présente invention a aussi trait à un dispositif de mise en oeuvre du procédé de contrôlé précédemment cité, comportant au moins un circuit de puissance, un circuit de commande, au moins un organe électrique à isoler distinct de l'organe électrique à contrôler, un système informatique composé d'au moins un calculateur permettant un pilotage du fonctionnement nominal de l'organe électrique, une base de données externe étant apte à communiquer avec le circuit de commande, un outil de mesure d'un courant pouvant être lié au circuit de puissance, **caractérisé en ce que** le système informatique comprend une mémoire permanente et une mémoire temporaire de sorte à ce qu'un code applicatif principal est mémorisé dans la mémoire permanente, tandis qu'un code applicatif secondaire est mémorisé dans la mémoire temporaire du calculateur.

Le procédé comporte aussi une étape préalable à l'exécution du code applicatif secondaire, qui consiste en un contrôle de la validité du code applicatif secondaire téléchargé dans la mémoire temporaire du système informatique du véhicule, cette étape de contrôle consistant à exécuter un programme de contrôle d'un marqueur associé au code applicatif secondaire, à calculer un second marqueur par une analyse du code applicatif secondaire, puis à comparer le marqueur téléchargé et le marqueur calculé, de sorte qu'une similitude entre le marqueur téléchargé et le marqueur calculé rende apte l'exécution dudit code applicatif secondaire.

Une étape d'initialisation des registres du calculateur a lieu ultérieurement au téléchargement du code applicatif secondaire et du marqueur associé dans la mémoire temporaire, l'étape d'initialisation des registres débute par une mise sous tension du calculateur.

De plus, le dispositif se caractérise en ce que la mémoire permanente du calculateur contient également un programme de contrôle de la validité d'un code applicatif secondaire, la validité du code se déterminant par une comparaison entre le marqueur téléchargé et un marqueur calculé.

D'autres particularités et avantages apparaîtront à la lecture de la description ci-après faite en référence à l'unique figure, donnée à titre d'exemple et de manière non limitative, dans laquelle est représenté, schématiquement et de manière simplifiée, un dispositif de mise en oeuvre du procédé de contrôle du fonctionnement d'un organe, selon l'invention.

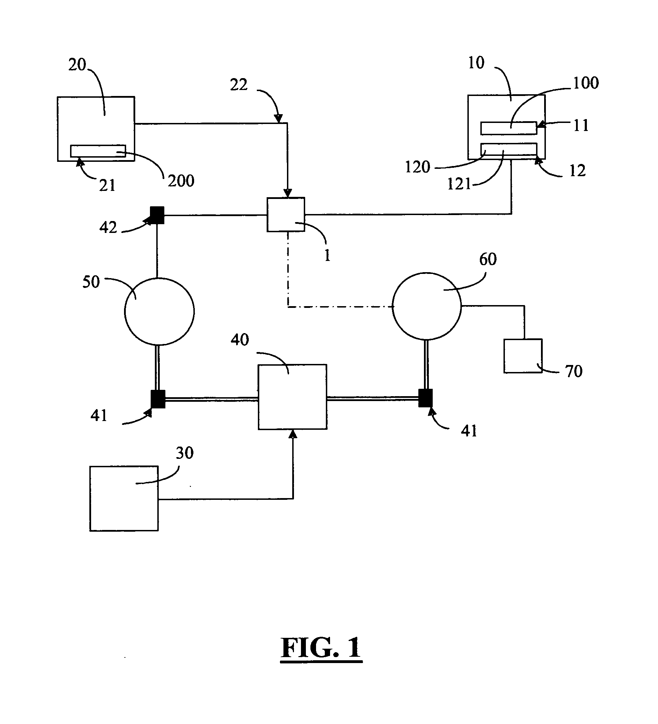

La fabrication d'un véhicule automobile comporte un contrôle de la conformité de production basé sur l'analyse du fonctionnement des différents organes 50, 60 électriques, tels des actionneurs ou des capteurs de mesure de grandeurs physiques. De tels organes électriques sont de préférence reliés à un circuit 40 de puissance, voire simultanément à un circuit 1 de commande, dont une illustration est donnée en figure 1, à titre d'exemple pour compléter la compréhension de l'invention.

Le véhicule automobile comportant de tels organes 50, 60 se compose notamment d'un système informatique comprenant le circuit 1 de commande mais aussi différents calculateurs 10 de pilotage du fonctionnement de certains organes 50 électriques.

Le contrôle peut consister en un relevé de la consommation d'un courant circulant dans un circuit 40 de puissance. En effet, une telle mesure a pour avantage d'indiquer le fonctionnement d'un organe 60 électrique de sorte qu'il est possible d'apprécier la qualité du branchement électrique de l'organe 60 électrique au circuit 40 de puissance. Compte tenu que chaque organe électrique peut être avantageusement identifié par la valeur du courant qu'il consomme lors d'une commande en fonctionnement nominal, une mesure du courant circulant dans le circuit 40 de puissance peut rendre aisé le contrôle du fonctionnement de l'organe 60 électrique alors monté sur le véhicule, par une analyse du courant consommé.

Ainsi, un opérateur présent en bout de ligne de montage s'applique à exécuter des mises en fonctionnement successives d'organes 60 consommant un courant et mesure, à l'aide d'un outil 30 de mesure dédié, le courant consommé. A l'aide d'une base de données contenue dans l'outil 30 de mesure, il paraît ainsi relativement aisé de contrôler le fonctionnement d'un organe 60 électrique, et d'apprécier ainsi la conformité de production.

Néanmoins, la mesure du courant circulant dans un circuit 40 de puissance est perturbée par des organes 50 électriques commandés en fréquence.

La présente invention permet avantageusement d'isoler temporairement au moins un organe 50 électrique sans procéder à un débranchement physique de l'organe impliqué.

On distingue ainsi des catégories distinctes d'organes électriques, ceux pour lesquels est envisagée la mesure du courant qu'ils consomment, et ceux à isoler temporairement du circuit 1 de commande, à savoir lesdits organes 50 électriques perturbateurs.

Le procédé de mesure du fonctionnement d'au moins un organe 60 électrique de la présente invention consiste à isoler au moins ledit organe 50 électrique, qualifié d'organe perturbateur, du circuit 1 de commande en utilisant des codes 120 d'inhibition de la commande dudit organe 50.

La liaison aux circuits de commande 1 et de puissance 40 d'un organe 50, 60 électrique est avantageusement réalisée par des connecteurs 41, 42 munis d'un moyen assurant contact électrique, telles des broches métalliques (non représentées). Afin de ne pas détériorer la qualité de la liaison électrique par des opérations de débranchement puis de branchement successives qui sont susceptibles de provoquer une déformation des broches métalliques des connecteurs 41, 42, le procédé de la présente invention consiste de préférence à exécuter un code 120 applicatif, nommé aussi code applicatif secondaire qui est destiné à inhiber la commande de l'organe 50 que l'on désire isoler du circuit 1 de commande.

Le calculateur 10 dédié notamment au pilotage du fonctionnement de l'organe 50 électrique comporte de préférence au moins une mémoire 11 dans laquelle est notamment stocké, par défaut, un code 110 applicatif principal. L'exécution du code 110 applicatif principal rend apte la commande de l'organe 50 en mode nominal, c'est-à-dire par des consignes de commandes prenant en compte des paramètres nominaux.

A contrario, l'exécution du code 120 applicatif secondaire rend apte l'inhibition de la commande de l'organe 50 électrique de sorte que, compte tenu d'un aspect sécuritaire à respecter, ledit code applicatif secondaire n'est pas stocké en permanence dans la mémoire du calculateur 10 dédié à la commande de l'organe 50.

Par conséquent, le code 120 applicatif est de préférence contenu dans une base 20 de données externe au système informatique contenu dans le véhicule. Pour pouvoir être exécuté, le code 120 applicatif secondaire doit être téléchargé de la base 20 de données vers une mémoire 12 temporaire appartenant au système informatique embarqué sur le véhicule.

Ainsi, le code 120 applicatif secondaire contenu dans un ensemble de données 200 est de préférence transmis de la base 20 au calculateur 10 associé à la commande de l'organe 50 électrique, par l'intermédiaire d'une liaison 22 électrique. Ainsi une exécution du code 120 applicatif secondaire par le calculateur 10 assure avantageusement l'effet technique recherché, à savoir une absence de perturbation de la mesure du courant circulant dans le circuit 40 de puissance, l'organe 50 qualifié de perturbateur pour la mesure du courant ayant été isolé par le calculateur 10 assurant le pilotage de son fonctionnement.

Afin de ne pas risquer une exécution intempestive, donc incontrôlée, du code 120 applicatif secondaire, qui est équivalent à un code d'inhibition de la commande de l'organe 50 qualifié de perturbateur, le procédé de l'invention envisage un téléchargement dudit code 120 applicatif secondaire dans une mémoire 12 temporaire qui est de préférence du type effaçable par une mise hors tension du calculateur 10, telle une mémoire RAM par exemple, de sorte que le code 120 secondaire est systématique effacé de la mémoire 12 du calculateur 10 lors d'une mise hors tension de tout ou partie du système informatique embarqué sur le véhicule automobile. Avantageusement, le risque d'exécuter, de manière inopinée, le code 120 applicatif secondaire est levé.

Plusieurs calculateurs 10 peuvent aussi être reliés aux circuits de commande 10, chacun pilotant de préférence au moins un organe 50, 60 électrique. Le fonctionnement en mode nominal desdits organes 50, 60 électriques est assuré avantageusement soit par une exécution desdits codes 110 principaux contenus dans les mémoires permanentes 11 des calculateurs 10, soit par une commande effectuée directement par un moyen 70 de sélection quasi manuelle.

C'est ainsi que pour une commande des organes électriques 50 effectuée par un calculateur 10, un pointeur programme évolue aux différentes adresses des mémoires 11, 12 du système informatique, permettant le cas échéant d'exécuter les codes 110, 120 applicatifs.

De préférence, ledit pointeur programme est apte à être positionné de manière quasi systématique, après chaque mise sous tension du système informatique, aux différentes adresses des différentes mémoires 12 temporaires, afin de vérifier la présence d'un ensemble de données 200 ayant été au préalable transmises par la base 20 externe de données, les données 200 étant de préférence le code 120 applicatif secondaire et un marqueur 121 associé.

A défaut de données 200 contenues en mémoire 12 temporaire, ledit pointeur programme est de préférence positionné aux adresses des codes 110 applicatifs principaux.

De préférence, le procédé comporte également une étape de vérification du contenu des données préalablement téléchargées dans la mémoire 12 temporaire.

Par conséquent le procédé de l'invention comprend une étape de détermination d'un second marqueur, pouvant être qualifié de marqueur calculé. Le marqueur calculé est de préférence défini d'après un programme contenu en mémoire 11 principale du calculateur 10.

Lesdits marqueur 121 téléchargé et marqueur calculé pourraient être par exemple d'un type connu, tel un « Cyclic Redundancy Check » (CRC) assurant une détection d'erreurs multiples contenues dans un ensemble de bits de données transmises, la détection pouvant s'effectuer par l'exécution d'un algorithme de division polynomiale. En l'espèce, l'algorithme de division polynomiale permet une détection éventuelle d'erreurs multiples contenues dans un ensemble de bits concernant le code 120 applicatif secondaire dédié à l'inhibition de la commande dudit organe 50 perturbateur. Ainsi, l'exécution de l'algorithme de division polynomiale contenu en mémoire 11 principale du calculateur est utile pour définir ledit marqueur calculé.

L'ensemble des données contenues dans la mémoire 12 temporaire contient le code 120 applicatif secondaire dédié à l'inhibition du fonctionnement d'un organe 50 électrique, mais aussi le marqueur 121 de sorte qu'en ayant défini ledit marqueur calculé, le procédé de l'invention prévoit une opération de comparaison entre le marqueur calculé et le marqueur 121 téléchargé. Une telle opération consiste à analyser la validité des données 200 transmises par comparaison du marqueur 121 téléchargé et dudit marqueur calculé.

Dans une situation d'équivalence entre les deux marqueurs, le programme d'inhibition de la commande de l'organe 50 électrique contenu dans la mémoire 12 temporaire du calculateur 10 est exécuté.

Dans une situation de divergence entre les deux marqueurs, seul le code 110 applicatif principal est exécuté.

Par conséquent, une fois l'inhibition dudit organe 50 perturbateur, le procédé de contrôle du fonctionnement de l'organe 60 électrique comprend une opération de mesure du courant consommé lors d'une mise en marche de l'organe 60 électrique à contrôler. L'opération de mesure du courant, réalisée en concomitance de l'inhibition de la commande des organes 50 électrique dont la commande doit être généralement du type en fréquence, consiste à connecter l'outil 30 de mesure sur le circuit 40 de puissance du véhicule.

Ainsi, lors de la mise en fonctionnement de l'organe 60 électrique à contrôler, l'outil 30 de contrôle indique une valeur du courant consommé qui n'est pas perturbée pas des commandes en fréquences jugées parasitaires.

En l'espèce, un tel procédé permet de contrôler la conformité de montage des organes 60 électriques, laquelle peut être donnée par la mesure du courant circulant dans le circuit 40 de puissance, tout en s'affranchissant des perturbations du champ magnétique provoquées par les commandes en fréquences d'autres organes 50.

## Revendications

1. Procédé de contrôle du fonctionnement d'au moins un premier organe (60) électrique relié à au moins un circuit de puissance (40) et/ou un circuit de commande (1) d'un véhicule automobile, un code (110) applicatif principal ayant été téléchargé dans une mémoire (11) d'un calculateur (10) pilotant un deuxième organe (50) électrique, **caractérisé en ce qu'**il consiste à télécharger des données (200) dans une mémoire (12) temporaire du calculateur (10), les données étant un code (120) applicatif secondaire et un marqueur (121) associé, à initialiser des registres du calculateur (10), à lire le contenu de la mémoire (12) temporaire du calculateur (10), à exécuter un code (110, 120) applicatif, le code (110) applicatif principal étant exécuté en une absence du code (120) applicatif secondaire de la mémoire (12) temporaire du calculateur (10), une exécution du code (110) applicatif principal étant destinée à piloter le fonctionnement nominal de l'organe (50) électrique, une exécution du code (120) applicatif secondaire visant à inhiber le fonctionnement de l'organe (50) électrique, l'isolant de la sorte du circuit (40) de puissance, puis à utiliser un moyen (30) de mesure d'un courant circulant dans le circuit (40) de puissance pour contrôler le fonctionnement de l'organe (60) électrique.

2. Procédé selon la revendication 1, **caractérisé en ce que,** préalablement à l'exécution du code (120) applicatif secondaire, le procédé comporte une étape de contrôle de la validité du code (120) applicatif secondaire.

3. Procédé selon la revendication 2, **caractérisée en ce que** l'étape de contrôle de la validité du code (120) applicatif secondaire consiste à exécuter un programme de contrôle d'un marqueur (121) associé au code (120) applicatif secondaire, à calculer un second marqueur par une analyse du code (120) applicatif secondaire, puis à comparer le marqueur (121) associé et le marqueur calculé, une similitude entre le marqueur (121) et le marqueur calculé rendant apte l'exécution dudit code (120) applicatif secondaire.

4. Procédé selon l'une quelconque des revendications 1 à 3, **caractérisé en ce qu'**une étape d'initialisation des registres du calculateur (10) a lieu ultérieurement au téléchargement du code (120) applicatif secondaire et du marqueur (121) associé dans la mémoire (12) temporaire du calculateur (10).

5. Procédé selon la revendication 4, **caractérisé en ce que** l'étape d'initialisation des registres débute par une mise sous tension du calculateur (10).

6. Procédé selon la revendication 5, **caractérisé en ce que** le code (120) applicatif secondaire est effacé de la mémoire (12) par une mise hors tension de tout ou partie du système informatique embarqué sur le véhicule.

7. Dispositif de mise en oeuvre du procédé de contrôle conforme aux revendications 1 à 6, comportant au moins un circuit (40) de puissance, un circuit (1) de commande, au moins un organe (50) électrique à isoler distinct de l'organe (60) à contrôler, un système informatique composé d'au moins un calculateur (10) permettant un pilotage du fonctionnement nominal de l'organe (50) électrique, une base (20) de données externe étant apte à communiquer avec le circuit (1) de commande, un outil (30) de mesure d'un courant pouvant être lié au circuit (40) de puissance, **caractérisé en ce que** le système informatique comprend une mémoire (11) permanente et une mémoire (12) temporaire de sorte à ce qu'un code (110) applicatif principal est mémorisé dans la mémoire (11) permanente, tandis qu'un code (120) applicatif secondaire est mémorisé dans la mémoire (12) temporaire du calculateur (10).

8. Dispositif selon la revendication 7, **caractérisé en ce que** la base (20) de données externe au système informatique du véhicule contient en mémoire (21) un ensemble de données (200) informatiques devant être transmises à la mémoire (12) temporaire du calculateur (10), ledit ensemble de données (200) informatiques comprenant le code (120) applicatif secondaire et le marqueur (121) associé.

9. Dispositif selon la revendication 8, **caractérisé en ce que** la mémoire (11) permanente du calculateur (10) contient également un programme de contrôle de la validité d'un code (120) applicatif secondaire, la validité du code (120) se déterminant par une comparaison entre le marqueur (121) téléchargé et un marqueur calculé.

## Claims

1. Method for controlling the operation of at least a first electrical element (60) connected to at least one power circuit (40) and/or a control circuit (1) for a motor vehicle, a main application code (110) having been downloaded into a memory of a calculator (10) controlling a second electrical element (50), **characterized in that** it consists in downloading data (200) into a volatile memory (12) of the calculator (10), the data being a secondary application code (120) and an associated marker (121), in initializing the registers of the calculator (10), in reading the content of the volatile memory (12) of the calculator (10), in executing an application code (110, 120), the main application code (110) being executed in the absence of the secondary application code (120) from the volatile memory (12) of the calculator (10), an execution of the main application code (110) being intended to control the nominal operation of the electrical element (50), an execution of the secondary application code (120) aiming to inhibit the operation of the electrical element (50), isolating it from the output of the power circuit (40), then to use a means (30) for measuring a current flowing in the power circuit (40) in order to monitor the operation of the electrical element (60).

2. Method according to Claim 1, **characterized in that,** prior to executing the secondary application code (120), the method comprises a step of checking the validity of the secondary application code (120).

3. Method according to Claim 2, **characterized in that** the step of checking the validity of the secondary application code (120) consists in executing a program for monitoring a marker (121) associated with the secondary application code (120), in calculating a second marker through an analysis of the secondary application code (120), then in comparing the associated marker (121) and the calculated marker, a likeness between the marker (121) and the calculated marker making execution of said secondary application code appropriate.

4. Method according to any one of the Claims 1 to 3, **characterized in that** a step of initializing the registers of the calculator (10) takes place after downloading the secondary application code (120) and the associated marker (121) into the volatile memory (12) of the calculator (10).

5. Method according to Claim 4, **characterized in that** the step of initializing the registers begins by switching on the calculator (10).

6. Method according to Claim 5, **characterized in that** the secondary application code (120) is deleted from the memory (12) by switching off all or part of the computer system on board the vehicle.

7. Device for implementing the control method according to Claims 1 to 5, comprising at least one power circuit (40), a control circuit (1), at least one electrical element (50) to be isolated distinct from the element (60) to be controlled, a computer system consisting of at least one calculator (10) enabling control of the nominal operation of the electrical element (50), an external database (20) being able to communicate with the control circuit (1), a current measurement device (30) that can be connected to the power circuit (40), **characterized in that** the computer system comprises a non-volatile memory (11) and a volatile memory (12) such that a main application code (110) is stored in the non-volatile memory (11), while a secondary application code (120) is stored in the volatile memory of the calculator (10).

8. Device according to Claim 7, **characterized in that** the external database (20) outside the computer system of the vehicle contains in memory (21) a set of computer data (200) that must be transmitted to the volatile memory of the calculator (10), said set of computer data (200) comprising the secondary application code (120) and the associated marker (121).

9. Device according to Claim 8, **characterized in that** the non-volatile memory (11) of the calculator (10) also contains a program for checking the validity of a secondary application code (120), the validity of the code (120) being determined by comparison between the downloaded marker (121) and a calculated marker.

## Patentansprüche

1. Verfahren zur Steuerung des Betriebs mindestens eines ersten elektrischen Elements (60), das mit mindestens einer Leistungsschaltung (40) und/oder einer Steuerschaltung (1) eines Kraftfahrzeugs verbunden ist, wobei ein Hauptanwendercode (110) in einen Speicher (11) eines Rechners (10), der ein zweites elektrisches Element (50) steuert, geladen wurde, **dadurch gekennzeichnet, dass** es darin besteht, Daten (200) in einen temporären Speicher (12) des Rechners (10) fern zu laden, wobei die Daten ein Nebenanwendercode (120) und ein zugehöriger Marker (121) sind, Register des Rechners (10) zu initialisieren, den Inhalt des temporären Speichers (12) des Rechners (10) abzulesen, einen Anwendercode (110, 120) auszuführen, wobei der Hauptanwendercode (110) bei Fehlen eines Nebenanwendercodes (120) des temporären Speichers (12) des Rechners (10) ausgeführt wird, wobei eine Ausführung des Hauptanwendercodes (110) dazu bestimmt ist, den Nominalbetrieb des elektrischen Elements (50) zu steuern, wobei eine Ausführung des Nebenanwendercodes (120) den Betrieb des elektrischen Elements (50) hemmen soll, wodurch es von der Leistungsschaltung (40) getrennt wird, dann ein Mittel (30) zum Messen eines Stroms, der in der Leistungsschaltung (40) zirkuliert, zu verwenden, um den Betrieb des elektrischen Elements (60) zu steuern.

2. Verfahren nach Anspruch 1, **dadurch gekennzeichnet, dass** vor der Ausführung des Nebenanwendercodes (120) das Verfahren einen Schritt der Kontrolle der Gültigkeit des Nebenanwendercodes (120) umfasst.

3. Verfahren nach Anspruch 2, **dadurch gekennzeichnet, dass** der Schritt der Kontrolle der Gültigkeit des Nebenanwendercodes (120) darin besteht, ein Kontrollprogramm eines Markers (121), der dem Nebenanwendercode (120) zugeordnet ist, auszuführen, einen zweiten Marker durch eine Analyse des Nebenanwendercodes (120) zu berechnen, dann den zugehörigen Marker (121) und den berechneten Marker zu vergleichen, wobei eine Ähnlichkeit zwischen dem Marker (121) und dem berechneten Marker zur Ausführung des Nebenanwendercodes (120) befähigt.

4. Verfahren nach einem der Ansprüche 1 bis 3, **dadurch gekennzeichnet, dass** ein Schritt der Initialisierung der Register des Rechners (10) nach der Fernladung des Nebenanwendercodes (120) und des zugehörigen Markers (121) in den temporären Speicher (12) des Rechners (10) erfolgt.

5. Verfahren nach Anspruch 4, **dadurch gekennzeichnet, dass** der Schritt der Initialisierung der Register mit einer Inbetriebsetzung des Rechners (10) beginnt.

6. Verfahren nach Anspruch 5, **dadurch gekennzeichnet, dass** der Nebenanwendercode (120) aus dem Speicher (12) durch eine Außerbetriebsetzung der Gesamtheit oder eines Teils des in das Fahrzeug eingebauten Informatiksystems gelöscht wird.

7. Vorrichtung für den Einsatz des Steuerungsverfahrens nach den Ansprüchen 1 bis 6, umfassend mindestens eine Leistungsschaltung (40), eine Steuerschaltung (1), mindestens ein von dem zu steuernden Element (60) getrenntes zu isolierendes elektrisches Element (50), ein Informatiksystem, umfassend mindestens einen Rechner (10), der eine Steuerung des Nominalbetriebs des elektrischen Elements (50) ermöglicht, eine externe Datenbasis (20), die mit der Steuerschaltung (1) kommunizieren kann, ein Werkzeug (30) zum Messen eines Stroms, das mit der Leistungsschaltung (40) verbunden sein kann, **dadurch gekennzeichnet, dass** das Informatiksystem einen Permanentspeicher (11) und einen temporären Speicher (12) umfasst, so dass ein Hauptanwendercode (110) in dem Permanentspeicher (11) gespeichert wird, während ein Nebenanwendercode (120) in dem temporären Speicher (12) des Rechners (10) gespeichert wird.

8. Vorrichtung nach Anspruch 7, **dadurch gekennzeichnet, dass** die zum Informatiksystem des Fahrzeugs externe Datenbasis (20) im Speicher (21) eine Gesamtheit von Informatikdaten (200) enthält, die an den temporären Speicher (12) des Rechners (10) übertragen werden müssen, wobei die Gesamtheit von Informatikdaten (200) den Nebenanwendercode (120) und den zugehörigen Marker (121) umfasst.

9. Vorrichtung nach Anspruch 8, **dadurch gekennzeichnet, dass** der Permanentspeicher (11) des Rechners (10) auch ein Programm zur Kontrolle der Gültigkeit eines Nebenanwendercodes (120) umfasst, wobei die Gültigkeit des Codes (120) durch einen Vergleich zwischen dem fern geladenen Marker (121) und einem berechneten Marker bestimmt wird.
